# EUROPEAN PATENT APPLICATION

(11) **EP 4 632 427 A1**
(43) Date of publication of application: **15.10.2025**
(21) Application number: 23910400.3
(22) Date of filing: 22.12.2023
(51) Int. Cl.: G01S 7/48, G01S 17/34, H01S 5/00

(54) **FREQUENCY SWEEP CONTROL METHOD AND APPARATUS**

(30) Priority: 30.12.2022 CN 202211729946
(71) Applicant: Shenzhen Yinwang Intelligent Technologies Co., Ltd., Shenzhen, Guangdong 518110 (CN)
(72) Inventor: YANG, Guangyao, Shenzhen, Guangdong 518129 (CN); SHI, Xianling, Shenzhen, Guangdong 518129 (CN); HUANG, Zhizhen, Shenzhen, Guangdong 518129 (CN)
(74) Representative: Maiwald GmbH
(86) International application number: PCT/CN2023/141048
(87) International publication number: WO 2024/140474

(57) **Abstract**

A frequency sweep control method and apparatus are provided. The method includes: outputting a first optical signal of a first laser unit (511), where a first frequency sweep range of the first optical signal is determined based on a first reference light emitting frequency and a first frequency variation upper limit; and switching to output a second optical signal of a second laser unit (512) when a first frequency variation of the first optical signal is greater than or equal to a first threshold, where a second frequency sweep range of the second optical signal is determined based on a second reference light emitting frequency and a second frequency variation upper limit, and the first threshold is less than the first frequency variation upper limit. The first frequency sweep range and the second frequency sweep range partially overlap, or the first frequency sweep range and the second frequency sweep range do not overlap, and the first reference light emitting frequency and the second reference light emitting frequency are different. **In** this way, a linear frequency sweep range output by a laser is expanded, a field of view interruption phenomenon caused by a non-ideal feature of a frequency sweep can be significantly reduced, to improve overall frequency sweep linearity.

## Description

This application claims priority to Chinese Patent Application No. 202211729946.2, filed with the China National Intellectual Property Administration on December 30, 2022, and entitled "FREQUENCY SWEEP CONTROL METHOD AND APPARATUS", which is incorporated herein by reference in its entirety.

### TECHNICAL FIELD

Embodiments of this application relate to the field of lasers, and more specifically, to a frequency sweep control method and apparatus.

### BACKGROUND

With the development of intelligence, lidars (light detection and ranging, LiDARs), for example, airborne lidars or vehicle-mounted lidars, have advantages of high reliability, long range, and high accuracy in measurement of external environments, and gradually become an important component in intelligent devices.

Currently, most of lidars used in intelligent vehicles implement accurate ranging based on a time of flight (time of flight, ToF). A measurement range of a ToF-based lidar depends on pulse power, and ranging accuracy of the ToF-based lidar depends on a pulse width. However, due to limitations on current technologies and material features of a laser, it is difficult to further increase a pulse peak and reduce the pulse width.

Measurement accuracy of a frequency-modulated continuous wave (frequency-modulated continuous wave, FMCW)-based lidar depends on a frequency sweep range, and a measurement signal-to-noise ratio of the FMCW-based lidar depends on a frequency sweep time. Improvement of the measurement accuracy and improvement of the measurement signal-to-noise ratio are not constrained by each other. However, a range of single frequency modulation of the FMCW-based lidar is still limited by physical performance of a laser diode.

Therefore, how to improve the frequency sweep range of the FMCW-based lidar is an urgent problem to be resolved.

### SUMMARY

Embodiments of this application provide a frequency sweep control method and apparatus, to implement a large-scale frequency sweep, thereby improving lidar measurement accuracy.

According to a first aspect, a frequency sweep control method is provided. The method includes: outputting a first optical signal of a first laser unit, where a first frequency sweep range of the first optical signal is determined based on a first reference light emitting frequency and a first frequency variation upper limit; and switching to output a second optical signal of a second laser unit when a first frequency variation of the first optical signal is greater than or equal to a first threshold, where a second frequency sweep range of the second optical signal is determined based on a second reference light emitting frequency and a second frequency variation upper limit, and the first threshold is less than the first frequency variation upper limit. The first frequency sweep range and the second frequency sweep range partially overlap, or the first frequency sweep range and the second frequency sweep range do not overlap, and the first reference light emitting frequency and the second reference light emitting frequency are different.

In the foregoing technical solution, different optical signals generated by two laser units are alternately output. Because reference light emitting frequencies of the different optical signals are different, and frequency sweep ranges of the different optical signals partially overlap or do not overlap, that at least two laser units alternately output optical signals may be equivalently considered as expansion of a linear frequency sweep range output by a laser. Compared with an architecture of a single laser unit or a single laser chip, this architecture can significantly reduce a field of view interruption phenomenon caused by a non-ideal feature of a frequency sweep, to improve overall frequency sweep linearity. In addition, costs are not significantly increased when a quantity of beam positions supported by a single channel in a single frequency sweep can be effectively increased, and a requirement for a scanning system is reduced.

With reference to the first aspect, in some implementations of the first aspect, the first threshold is less than the first frequency variation upper limit. Switching to output the second optical signal of the second laser unit when the first frequency variation of the first optical signal is greater than or equal to the first threshold includes: when the first frequency variation is greater than or equal to a second threshold, turning on the second laser unit, and when the first frequency variation is greater than or equal to the first threshold, switching to output the second optical signal, where the second threshold is less than the first threshold.

In the foregoing technical solution, before the first frequency variation of the first optical signal reaches the first frequency variation upper limit, switching to output the second optical signal from the second laser unit is performed through an optical switch unit. This can avoid tens of microseconds of field of view interruption caused by a limitation of a basic modulation principle of the laser units before the first optical signal reaches the first frequency variation upper limit, thereby improving ranging stability of a laser.

With reference to the first aspect, in some implementations of the first aspect, the method further includes: when a second frequency variation of the second optical signal is greater than or equal to a third threshold, switching to output another optical signal other than the second optical signal, where the third threshold is less than the second frequency variation upper limit.

With reference to the first aspect, in some implementations of the first aspect, the method further includes: determining that the first optical signal and an interference echo optical signal interfere with each other, where a frequency difference between a frequency of the first optical signal and a frequency of the interference echo optical signal is less than an interference threshold, and a first field of view and a second field of view overlap; and adjusting a sending strategy for the first optical signal, the second optical signal, and the another optical signal, where a first laser corresponding to the interference echo optical signal is different from a second laser corresponding to the first optical signal, the first field of view is a field of view of the first laser, and the second field of view is a field of view of the second laser.

In the foregoing technical solution, when the laser experiences multi-lidar interference, the sending strategy for the optical signals of the different laser units may be adjusted, to overcome impact caused by multi-lidar interference, thereby maintaining working stability of the laser.

With reference to the first aspect, in some implementations of the first aspect, adjusting the sending strategy for the first optical signal, the second optical signal, and the another optical signal includes: when the interference echo optical signal is a long-chirp optical signal, adjusting a sending sequence of the first optical signal, the second optical signal, and the another optical signal, so that the first optical signal and the interference echo optical signal do not overlap in time domain.

In the foregoing technical solution, a light emitting sequence of the laser units is adjusted, so that interference of the long chirp can be efficiently avoided, to maintain working stability of the laser.

With reference to the first aspect, in some implementations of the first aspect, the another optical signal is a third optical signal, and the third optical signal is determined based on a third reference light emitting frequency and a third frequency variation upper limit; and adjusting the sending strategy for the first optical signal, the second optical signal, and the another optical signal includes: when the interference echo optical signal is a short-chirp optical signal, disabling the output of the first optical signal, and adjusting a sending sequence of the second optical signal and the third optical signal, where the second optical signal and the third optical signal are contiguous in time domain.

In the foregoing technical solution, the light emitting sequence of the laser units is adjusted, and output of an interfered optical signal is shielded, so that interference of the short chirp can be efficiently avoided, to maintain working stability of the laser.

With reference to the first aspect, in some implementations of the first aspect, the another optical signal is a third optical signal, and the third optical signal is determined based on a third reference light emitting frequency and a third frequency variation upper limit; and the method further includes: alternately outputting the first optical signal, the second optical signal, and the third optical signal in a random sequence; when it is detected that noise exists in a first field of view, and spatial distribution of the noise in the second field of view and spatial distribution of the first optical signal in the second field of view overlap, determining that the first optical signal and an interference echo optical signal corresponding to the noise interfere with each other; and adjusting a sending strategy for the first optical signal, the second optical signal, and the third optical signal, where a first laser corresponding to the interference echo optical signal is different from a second laser corresponding to the first optical signal, and the second field of view is a field of view of the second laser.

With reference to the first aspect, in some implementations of the first aspect, adjusting the sending strategy for the first optical signal, the second optical signal, and the third optical signal includes: obtaining time domain positions of the first optical signal, the second optical signal, and the third optical signal that are randomly sent; and disabling the output of the first optical signal at the time domain position for sending the first optical signal.

In the foregoing technical solution, the interference echo optical signal is identified based on a random light emitting sequence of the laser units, and output of an interfered optical signal is shielded, so that interference of the short chirp can be efficiently avoided, to maintain working stability of the laser.

According to a second aspect, a frequency sweep control apparatus is provided. The apparatus includes a first laser unit, a second laser unit, a first optical switch unit, a second optical switch unit, and an optical combining unit; the first laser unit is configured to send a first optical signal to the optical combining unit through the first optical switch unit, where a first frequency sweep range of the first optical signal is determined based on a first reference light emitting frequency and a first frequency variation upper limit, and the first optical switch unit is in an on state; the optical combining unit is configured to output the first optical signal; the second laser unit is configured to send a second optical signal to the optical combining unit through the second optical switch unit when a first frequency variation of the first optical signal is greater than or equal to a first threshold, where a second frequency sweep range of the second optical signal is determined based on a second reference light emitting frequency and a second frequency variation upper limit, and the first threshold is less than the first frequency variation upper limit; and the optical combining unit switches to output the second optical signal, where the first optical switch unit is in an off state, and the second optical switch unit is in an on state; and the first frequency sweep range and the second frequency sweep range partially overlap, or the first frequency sweep range and the second frequency sweep range do not overlap, and the first reference light emitting frequency and the second reference light emitting frequency are different.

It should be understood that technical effects corresponding to the frequency sweep control apparatus in the second aspect are similar to technical effects of the first aspect. Details are not described herein again.

With reference to the second aspect, in some implementations of the second aspect, the first threshold is less than the first frequency variation upper limit, when the first frequency variation is greater than or equal to a second threshold, the second laser unit is turned on, and when the first frequency variation is greater than or equal to the first threshold, the second laser unit is configured to send the second optical signal to the optical combining unit through the second optical switch unit, where the second threshold is less than the first threshold.

With reference to the second aspect, in some implementations of the second aspect, when a second frequency variation of the second optical signal is greater than or equal to a third threshold, the optical combining unit switches to output another optical signal other than the second optical signal, where the second optical switch unit is in an off state, and the third threshold is less than the second frequency variation upper limit.

With reference to the second aspect, in some implementations of the second aspect, the apparatus further includes another optical switch unit, a detection unit, and a control unit. The detection unit is configured to determine that the first optical signal and an interference echo optical signal interfere with each other, where a frequency difference between a frequency of the first optical signal and a frequency of the interference echo optical signal is less than an interference threshold, and a first field of view and a second field of view overlap; and the control unit is configured to control the first optical switch unit, the second optical switch unit, and the another optical switch unit, to adjust a sending strategy for the first optical signal, the second optical signal, and the another optical signal, where a first laser corresponding to the interference echo optical signal is different from a second laser corresponding to the first optical signal, the first field of view is a field of view of the first laser, and the second field of view is a field of view of the second laser.

With reference to the second aspect, in some implementations of the second aspect, the control unit is specifically configured to: when the interference echo optical signal is a long-chirp optical signal, control the first optical switch unit, the second optical switch unit, and the another optical switch unit, to adjust a sending sequence of the first optical signal, the second optical signal, and the another optical signal, so that the first optical signal and the interference echo optical signal do not overlap in time domain.

With reference to the second aspect, in some implementations of the second aspect, the another optical switch unit is a third optical switch unit, the another optical signal is a third optical signal, and the third optical signal is determined based on a third reference light emitting frequency and a third frequency variation upper limit. The control unit is specifically configured to: when the interference echo optical signal is a short-chirp optical signal, control the first optical switch unit to disable the output of the first optical signal, and control the first optical switch unit and the third optical switch unit, to adjust a sending sequence of the second optical signal and the third optical signal, where the second optical signal and the third optical signal are contiguous in time domain.

With reference to the second aspect, in some implementations of the second aspect, the another optical signal is a third optical signal, and the third optical signal is determined based on a third reference light emitting frequency and a third frequency variation upper limit; and the apparatus further includes a third optical switch unit, a detection unit, and a control unit; the control unit is configured to control the first optical switch unit, the second optical switch unit, and the third optical switch unit, so that the first optical signal, the second optical signal, and the third optical signal are alternately output in a random sequence; the detection unit is configured to: when it is detected that noise exists in a second field of view, and spatial distribution of the noise in the second field of view and spatial distribution of the first optical signal in the second field of view overlap, determine that the first optical signal and the interference echo optical signal corresponding to the noise interfere with each other; and the control unit is configured to control the first optical switch unit, the second optical switch unit, and the third optical switch unit, to adjust a sending strategy for the first optical signal, the second optical signal, and the third optical signal, where a first laser corresponding to the interference echo optical signal is different from a second laser corresponding to the first optical signal, and the second field of view is a field of view of the second laser.

With reference to the second aspect, in some implementations of the second aspect, the control unit is specifically configured to: obtain time domain positions of the first optical signal, the second optical signal, and the third optical signal that are randomly sent; and control the first optical switch unit to disable the output of the first optical signal at the corresponding time domain position for sending the first optical signal.

According to a third aspect, a lidar is provided, including the frequency sweep control apparatus according to the second aspect or any one of the implementations of the second aspect.

According to a fourth aspect, a mobile carrier is provided, including the lidar according to the third aspect.

With reference to the fourth aspect, in some implementations of the fourth aspect, the mobile carrier is a vehicle.

It should be understood that the mobile carrier may further include a vehicle on a road, a vehicle on water, an air vehicle, an industrial device, an agricultural device, an entertainment device, or the like. For example, the mobile carrier may be a vehicle in a broad sense, and may be a vehicle (for example, a commercial vehicle, a passenger vehicle, a motorcycle, a flight vehicle, or a train), an industrial vehicle (for example, a pallet truck, a trailer, or a tractor), an engineering vehicle (for example, an excavator, a bulldozer, or a crane), an agricultural device (for example, a lawn mower or a harvester), a recreation device, a toy vehicle, and the like. A type of the vehicle is not limited in embodiments of this application. For another example, the mobile carrier may be a vehicle such as an aircraft, an uncrewed aerial vehicle, or a ship.

### BRIEF DESCRIPTION OF DRAWINGS

FIG. 1 is a diagram of an application scenario of a lidar according to an embodiment of this application;
FIG. 2 is a diagram of another application scenario of a lidar according to an embodiment of this application;
FIG. 3 is a diagram of a structure of an FMCW-based lidar according to an embodiment of this application;
FIG. 4 is a diagram of a frequency sweep waveform of a laser according to an embodiment of this application;
FIG. 5 is a diagram of a frequency sweep control apparatus according to an embodiment of this application;
FIG. 6 is a diagram of a frequency sweep control method according to an embodiment of this application;
FIG. 7 is a diagram of a frequency sweep control process according to an embodiment of this application;
FIG. 8 is a diagram of a frequency sweep result according to an embodiment of this application;
FIG. 9 is a diagram of another frequency sweep control process according to an embodiment of this application;
FIG. 10 is a diagram of another frequency sweep result according to an embodiment of this application;
FIG. 11 is a diagram of still another frequency sweep result according to an embodiment of this application; and
FIG. 12 is a diagram of yet another frequency sweep result according to an embodiment of this application.

### DESCRIPTION OF EMBODIMENTS

The following describes technical solutions of embodiments in this application with reference to accompanying drawings.

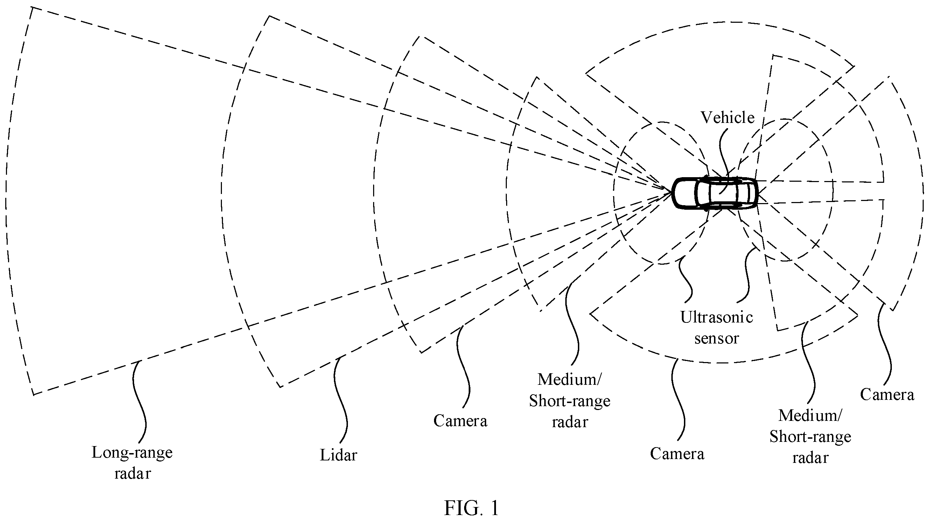

FIG. 1 is a diagram of an application scenario of a lidar according to an embodiment of this application.

As shown in FIG. 1, the lidar is an important device in environment sensing of an intelligent vehicle. FIG. 1 is a diagram of sensing ranges of various sensors. The sensors may include a lidar, a millimeter-wave radar, a camera apparatus, and an ultrasonic sensor shown in FIG. 1. The millimeter-wave radar may be classified into a long-range radar and a medium/short-range radar.

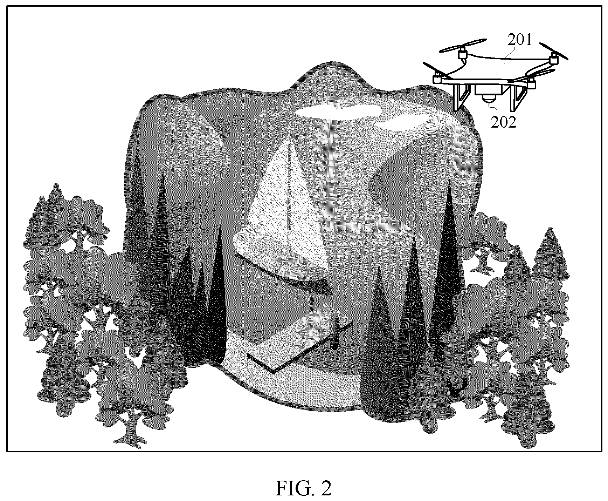

FIG. 2 is a diagram of another application scenario of a lidar according to an embodiment of this application.

As shown in FIG. 2, the lidar in this application may be further used in a mapping technology and a remote sensing technology. 201 is an uncrewed aerial vehicle, and 202 is the lidar. The lidar on the uncrewed aerial vehicle may perform topographic mapping, or may perform urban traffic mapping. This is not limited in this embodiment of this application.

For ease of understanding this application, terms in this application are first explained.

### 1. Coherent detection

Coherent detection is a detection manner in which, a coherent laser signal and a local laser oscillation signal that meet a condition of wavefront matching are incident to a photosensitive surface of a detector together to generate a beat frequency or coherent superposition, and a size of an electrical signal output by the detector is proportional to a square of a sum of a to-be-measured laser signal wave and a local laser oscillation wave of a local device.

### 2. Chirp

A chirp is a signal in which a frequency increases or decreases with time.

### 3. Frequency sweep range

A frequency sweep range of an FMCW laser is a range of single frequency modulation of the laser. For example, if the range of single frequency modulation is [F, F+100 GHz], it may be understood that a frequency range of single continuous linear frequency modulation is [F, F+100 GHz], where F is a reference light emitting frequency, and 100 GHz is a frequency variation upper limit of the FMCW laser.

### 4. Frequency sweep slope

A frequency sweep slope of an optical signal is equal to a frequency variation upper limit of the optical signal divided by a frequency sweep time.

Currently, a lidar may be roughly classified into two types: one based on a ToF technology, and the other based on an FMCW technology.

A ToF-based lidar implements ranging based on an interval between an echo receiving time after a light pulse is reflected by an object and a transmitting time. A measurement range of the ToF-based lidar depends on pulse power, and measurement accuracy depends on a pulse width. It is difficult to further increase pulse peak power and reduce the pulse width due to the limitations of current laser technologies and a material feature.

An FMCW-based lidar transmits a linear frequency sweep continuous light wave as a detection optical signal, and uses same-source linear frequency sweep continuous light that is highly coherent with the detection signal as a local oscillation optical signal. Coherent detection is performed on the local oscillation optical signal and an echo optical signal of the detection optical signal to obtain a single-frequency signal. A center frequency of the single-frequency signal is proportional to a range between the lidar and a target object. Measurement accuracy of FMCW technologies depends on a frequency sweep range, and a measurement signal-to-noise ratio depends on a frequency sweep time.

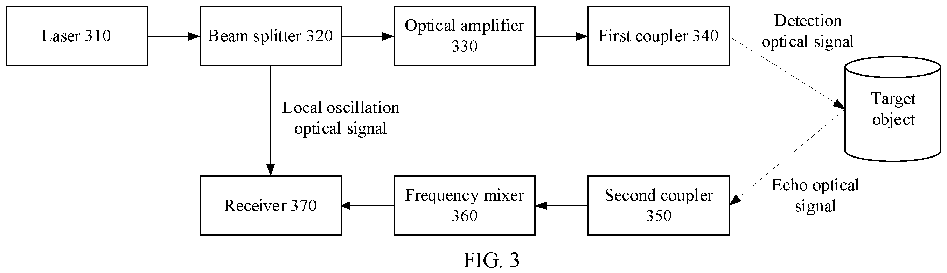

FIG. 3 is a diagram of a structure of an FMCW-based lidar according to an embodiment of this application.

As shown in FIG. 3, the FMCW-based lidar includes a laser 310, a beam splitter 320, an optical amplifier 330, a first coupler 340, a second coupler 350, a frequency mixer 360, and a receiver 370. The laser 310 may be, for example, a laser or another type of laser. This is not limited in this embodiment of this application.

The laser 310 generates a frequency sweep optical signal, and the frequency sweep optical signal enters the beam splitter 320. A part of the frequency sweep optical signal enters the optical amplifier 330 and the first coupler 340, and is sent as a detection optical signal. The other part of the frequency sweep optical signal enters the receiver 370 as a local oscillation optical signal. After the detection optical signal scans a target object, an echo optical signal is generated. The echo optical signal passes through the second coupler 350 and the frequency mixer 360, and enters the receiver 370. Coherent detection is performed on the echo optical signal and the local oscillation optical signal in the receiver 370 to form an electrical signal having a specific frequency, and data collection and processing are completed by a digital signal processing (digital signal processing, DSP) module.

It should be understood that the structure of the FMCW-based lidar shown in FIG. 3 is merely an example form. A structure of the FMCW-based lidar is not limited in this embodiment of this application.

Mode-hop-free tuning in a semiconductor laser is limited by a physical performance limit of a laser diode, and consequently, a frequency sweep range of the semiconductor laser cannot exceed 100 GHz. In a current lidar architecture, a frequency sweep range of 100 GHz corresponds to 100 beam positions. Currently, a single frame of the FMCW-based lidar needs to detect 1200×300 beam positions. In other words, the lidar has 300 lines, and each line detects 1200 points. These form point cloud data of the single frame. Because a range of single frequency modulation is only 100 beam positions, that is, only 100 points can be detected at a time, if a quantity of transmit and receive channels is less than 12, fast axis scanning needs to be performed in a vertical direction. Because gravity needs to be overcome, a requirement on a scanner is high.

Currently, there is a method for generating a large-range linear frequency-modulated continuous light wave by using an optical phase lock loop technology. A main principle of the optical phase lock loop technology is that an optical phase lock structure is configured to drive a semiconductor laser to generate linear frequency-modulated continuous light. An asymmetric Mach-Zehnder interferometer (asymmetric Mach-Zehnder interferometer, AMZI) structure is used to detect an error between a frequency sweep and linear frequency modulation of the semiconductor laser. An error signal is integrated, by using a charge pump structure, and then superposed with a sawtooth signal, to drive the semiconductor laser together to generate an FMCW signal.

In the foregoing manner, although a linear frequency modulation range can be increased, a minimum requirement of the FMCW-based lidar still cannot be met.

Currently, there is also a solution for implementing cavity length tuning by using an external mechanical tuning resonant cavity, to obtain frequency-modulated continuous light emitting. An external cavity laser of a Littrow structure is used, where a tunable component is a diffraction grating, and an angle of the diffraction grating is rotated, so that a wavelength of light reflected back from the diffraction grating to the laser can be controlled, to implement continuous wavelength tuning and cavity length control. An external cavity laser of a Littman structure is used, and an angle of a reflector is changed, so that a resonance wavelength is controlled, to implement continuous wavelength tuning.

In this solution, although ultra-large-range mode-hop-free continuous wavelength tuning can be implemented, that is, large-range linear frequency modulation can be implemented, this solution relies on a large precision mechanical structure. Consequently, stability and costs of the solution are limited, and the solution is not suitable for an application scenario of a vehicle-mounted lidar or an airborne lidar.

In addition, when the laser performs a frequency sweep, due to limitation of a basic principle of laser modulation, a frequency sweep is easily interrupted at a turning point of change of a chirp signal.

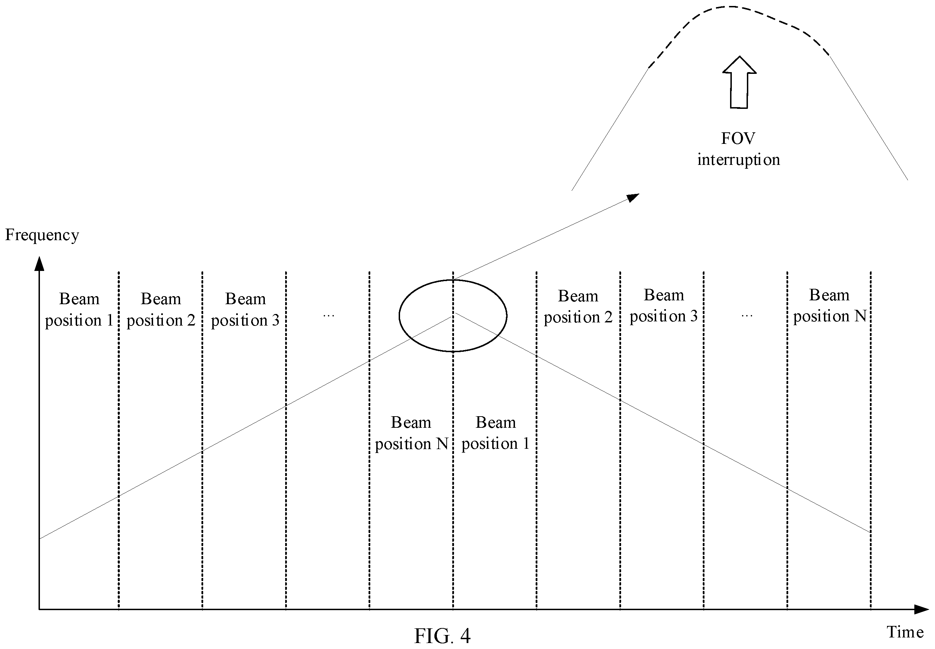

FIG. 4 is a diagram of a frequency sweep waveform of a laser according to an embodiment of this application.

A frequency sweep waveform shown in FIG. 4 is a triangular wave. In the triangular wave, a frequency sweep signal whose frequency increases with time may be referred to as an up-chirp, and a frequency sweep signal whose frequency decreases with time may be referred to as a down-chirp. At a turning point of the up-chirp and the down-chirp, due to limitation of a basic principle of laser modulation, dozens of microseconds need to be sacrificed. In other words, when a field of view (field of view, FOV) of the laser is interrupted, ranging cannot be implemented.

In addition, although the FMCW-based lidar has a better anti-interference capability than the ToF-based lidar in terms of natural light, if frequencies of detection signals of two FMCW-based lidars are close, and field-of-view ranges of the two lidars overlap, echo signals of the two lidars interfere with each other. The problem of multi-lidar interference is not considered in the foregoing two solutions.

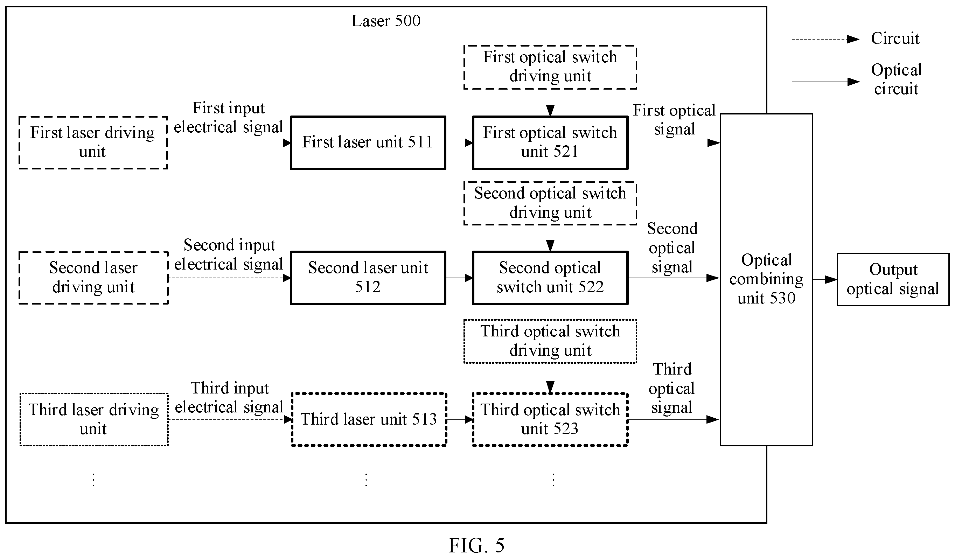

In view of this, an embodiment of this application provides a frequency sweep control apparatus, to resolve the foregoing problem. The following describes the frequency sweep control apparatus in detail with reference to FIG. 5 to FIG. 12.

For ease of understanding of embodiments of this application, the following descriptions are provided.

First, in this application, unless otherwise stated or there is a logic conflict, terms and/or descriptions in different embodiments are consistent and may be mutually referenced, and technical features in different embodiments may be combined based on an internal logical relationship thereof, to form a new embodiment.

Second, in this application, "a plurality of" means two or more than two. The term "and/or" describes an association relationship between associated objects and represents that three relationships may exist. For example, A and/or B may represent the following three cases: Only A exists, both A and B exist, and only B exists. A and B may be singular or plural. In text descriptions of this application, the character "/" usually indicates an "or" relationship between associated objects.

Third, in this application, "first" and "second" are merely used for differentiation for ease of description, but are not intended to limit the scope of embodiments of this application. For example, "first" and "second" are intended to distinguish between different optical signals, but not to describe a specific sequence or sequence. It should be understood that objects described in this way are interchangeable in an appropriate circumstance, so that a solution other than embodiments of this application can be described.

Fourth, in this application, the descriptions "when...", "in a case that... ", "if", and the like all mean that a device performs corresponding processing in an objective case, but are not intended to limit time. The descriptions do not require that the device performs a determining action during implementation, and do not mean another limitation.

Fifth, in this application, the terms "include" and "have" and any other variants are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

FIG. 5 is a diagram of a frequency sweep control apparatus according to an embodiment of this application.

It should be understood that the frequency sweep control apparatus may also be referred to as a "laser". The laser 500 shown in FIG. 5, for example, may be a semiconductor laser.

The laser 500 includes a first laser unit 511, a second laser unit 512, a first optical switch unit 521, a second optical switch unit 522, and an optical combining unit 530.

The first laser unit 511 is configured to send a first optical signal to the optical combining unit 530 through the first optical switch unit 521, where a first frequency sweep range of the first optical signal is determined based on a first reference light emitting frequency and a first frequency variation upper limit, and the first optical switch unit is in an on state.

It should be understood that it is assumed that the first reference light emitting frequency is F1, and the first frequency variation upper limit is a, and in this case, the first frequency sweep range is [F1, F1±a], where both F1 and a are positive numbers. Values of F1 and a are related to physical performance of the first laser unit, that is, related to physical performance of a first laser chip. Whether a frequency of an optical signal increases or decreases is not limited in this embodiment of this application.

Optionally, the laser 500 may further include a first laser driving unit and a first optical switch driving unit.

In a possible implementation, the first laser driving unit generates a first input electrical signal for driving linear frequency modulation of the first laser unit 511, and the first input electrical signal is input to the first laser unit 511, to obtain the first optical signal. The first optical switch driving unit generates a first switch electrical signal for driving the first optical switch unit 521, to control the first optical switch unit 521 to be in the on state, so that the first optical signal is sent to the optical combining unit 530.

The optical combining unit 530 outputs the first optical signal.

The second laser unit 512 is configured to send a second optical signal to the optical combining unit 530 through the second optical switch unit 522 when a first frequency variation of the first optical signal is greater than or equal to a first threshold, where a second frequency sweep range of the second optical signal is determined based on a second reference light emitting frequency and a second frequency variation upper limit, and the first threshold is less than the second frequency variation upper limit. The optical combining unit switches to output the second optical signal, where the first optical switch unit is in an off state, and the second optical switch unit is in an on state.

It should be understood that it is assumed that the second reference light emitting frequency is F2, and the second frequency variation upper limit is b, and in this case, the second frequency sweep range is [F2, F2+b], where both F2 and b are positive numbers. Values of F2 and b are related to physical performance of the second laser unit, that is, related to physical performance of a second laser chip.

It should be further understood that the first frequency variation is a positive value, and is not affected by whether a frequency of the optical signal increases or decreases, and the first threshold is a positive value.

The first frequency sweep range and the second frequency sweep range partially overlap, or the first frequency sweep range and the second frequency sweep range do not overlap, and the first reference light emitting frequency and the second reference light emitting frequency are different.

It should be understood that the first frequency variation upper limit may be the same as or different from the second frequency variation upper limit. This is not limited in this embodiment of this application. In addition, a first frequency sweep slope of the first optical signal may be the same as or different from a second frequency sweep slope of the second optical signal. The following embodiment is described in detail by using an example in which the first frequency variation upper limit is the same as the second frequency variation upper limit, and the first frequency sweep slope is the same as the second frequency sweep slope.

It should be further understood that, that the first frequency sweep range and the second frequency sweep range partially overlap does not include a case in which all of the first frequency sweep range and a part of the second frequency sweep range overlap, or all of the second frequency sweep range and a part of the first frequency sweep range overlap.

Optionally, when the first frequency variation is greater than or equal to a second threshold, the second laser unit is turned on, and when the first frequency variation is greater than or equal to the first threshold, the second optical signal is switched to be output, where the second threshold is less than the first threshold.

In this way, before the first frequency variation of the first optical signal reaches the first frequency variation upper limit, switching to output the second optical signal from the second laser unit is performed through an optical switch unit. This can avoid tens of microseconds of field of view interruption caused by a limitation of a basic modulation principle of the laser units before the first optical signal reaches the first frequency variation upper limit, thereby improving ranging stability of the laser.

Optionally, the laser 500 may further include a second laser driving unit and a second optical switch driving unit.

In a possible implementation, the second laser driving unit generates a second input electrical signal for driving linear frequency modulation of the second laser unit 512, and the second input electrical signal is input to the second laser unit 512, to obtain the second optical signal. The first optical switch driving unit generates the first switch electrical signal for driving the first optical switch unit 521, to control the first optical switch unit 521 to be in the off state, and the second optical switch driving unit generates the second switch electrical signal for driving the second optical switch unit 521, to control the second optical switch unit 521 to be in the on state, so that the first optical signal is sent to the optical combining unit 530.

The optical combining unit 530 is configured to switch to output the second optical signal.

Optionally, when a second frequency variation of the second optical signal is greater than or equal to a third threshold, the optical combining unit 530 switches to output another optical signal other than the second optical signal, where the second optical switch unit 522 is in an off state, and the third threshold is less than the second frequency variation upper limit.

In a possible implementation, the another optical signal may be the first optical signal. In this case, the second optical switch unit 522 is in the off state, and the first optical switch unit 521 is in the on state.

It should be understood that the first threshold may be the same or different from the third threshold. For example, when the first frequency variation upper limit is the same as the second frequency variation upper limit, the first threshold may be the same as the third threshold.

In a possible implementation, when the first frequency variation upper limit is the same as the second frequency variation upper limit, and the first frequency sweep slope is the same as the second frequency sweep slope, the first threshold may be the same as the third threshold. In this case, switching to output the second optical signal from the first optical signal and switching to output another optical signal from the second optical signal may be performed at equal time intervals.

In a possible implementation, the another optical signal may be a third optical signal. In this case, the laser 500 may further include a third laser unit 513 and a third optical switch unit 523, where the second optical switch unit 522 is in the off state, the first optical switch unit 521 is in the off state, and the third optical switch unit 523 is in an on state.

Optionally, the laser 500 may further include a third laser driving unit and a third optical switch driving unit.

For a specific process of switching to output the another optical signal other than the second optical signal, refer to the foregoing process of outputting the second optical signal. Details are not described herein again.

It should be understood that the laser 500 may further include more laser units and more optical switch units. A quantity of laser units and a quantity of optical switch units are not limited in this embodiment of this application. An on or off state of each optical switch unit is controlled, so that an optical signal generated by only one laser unit is output at a specific moment. In other words, optical signals generated by different laser units are output alternately.

In a possible implementation, each optical switch unit in the laser 500 is an independent optical switch unit.

For example, as shown in FIG. 5, the first optical switch unit 521, the second optical switch unit 522, and the third optical switch unit 523 all implement state switching by using respective independent optical switch driving units.

In a possible implementation, all optical switch units in the laser 500 form a single-pole multi-throw optical switch unit.

Therefore, in this embodiment of this application, different optical switch units may be independent of each other, or a plurality of optical switch units may form a single-pole multi-throw optical switch unit.

In the foregoing technical solution, different optical signals generated by two laser units are alternately output. Because reference light emitting frequencies of the different optical signals are different, and frequency sweep ranges of the different optical signals partially overlap or do not overlap, that at least two laser units alternately output optical signals may be equivalently considered as expansion of a linear frequency sweep range output by a laser. Compared with an architecture of a single laser unit or a single laser chip, this architecture can significantly reduce a field of view interruption phenomenon caused by a non-ideal feature of a frequency sweep, to improve overall frequency sweep linearity. In addition, costs are not significantly increased when a quantity of beam positions supported by a single channel in a single frequency sweep can be effectively increased, and a requirement for a scanning system is reduced.

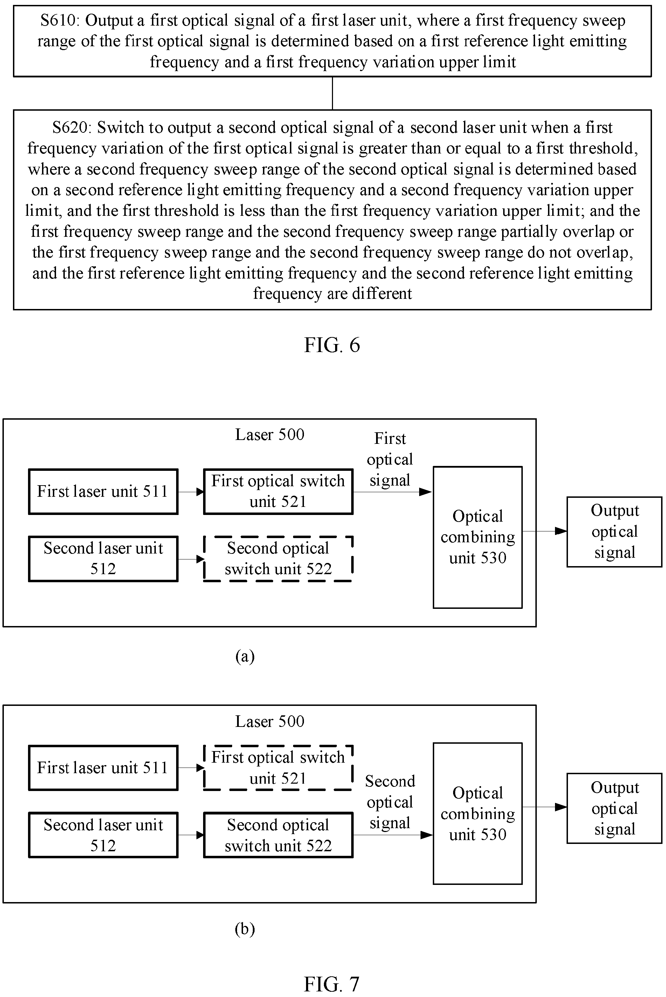

FIG. 6 is a diagram of a frequency sweep control method according to an embodiment of this application. The method may be applied to the apparatus shown in FIG. 5.

S610: Output a first optical signal of a first laser unit, where a first frequency sweep range of the first optical signal is determined based on a first reference light emitting frequency and a first frequency variation upper limit.

S620: Switch to output a second optical signal of a second laser unit when a first frequency variation of the first optical signal is greater than or equal to a first threshold, where a second frequency sweep range of the second optical signal is determined based on a second reference light emitting frequency and a second frequency variation upper limit, and the first threshold is less than the first frequency variation upper limit. The first frequency sweep range and the second frequency sweep range partially overlap, or the first frequency sweep range and the second frequency sweep range do not overlap, and the first reference light emitting frequency and the second reference light emitting frequency are different.

It should be understood that, because the frequency sweep control method shown in FIG. 6 may be implemented by using the laser 500 shown in FIG. 5, for more detailed content in the method shown in FIG. 6, refer to related descriptions in FIG. 5.

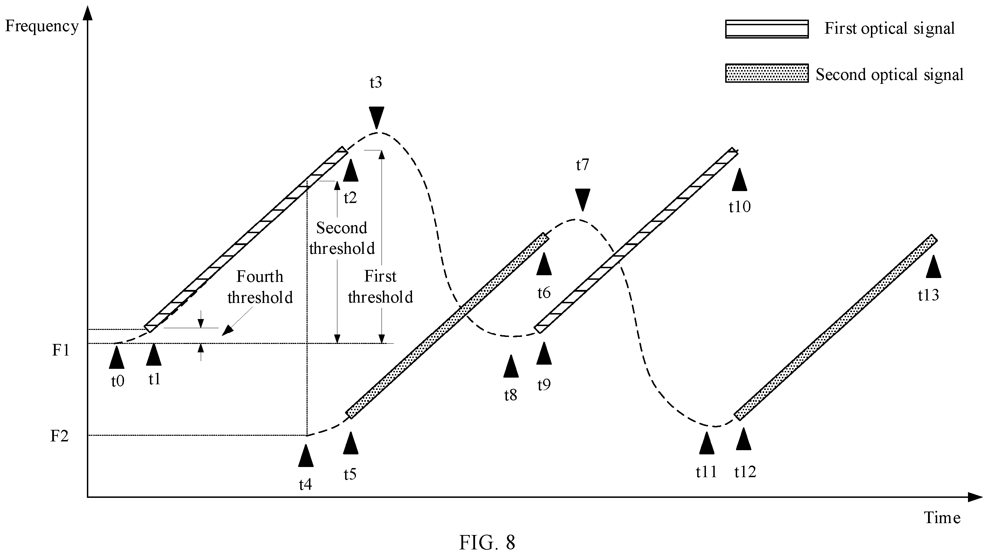

With reference to FIG. 7 and FIG. 8, the following uses an example in which a laser includes two laser units to describe in detail a frequency sweep control method in this application to expand a linear frequency sweep range of the laser.

FIG. 7 is a diagram of a frequency sweep control process according to an embodiment of this application. FIG. 8 is a diagram of a frequency sweep result according to an embodiment of this application.

The laser 500 in FIG. 7 is a simplified laser 500 in FIG. 5, and the laser driving units and the optical switch driving units are omitted. It should be understood that the omission herein is an omission in the figure, and is not an omission of a component in an actual apparatus.

It should be further understood that the first frequency variation upper limit of the first laser unit 511 shown in FIG. 7 and FIG. 8 is the same as the second frequency variation upper limit of the second laser unit 512, and the first frequency sweep slope of the first optical signal is the same as the second frequency sweep slope of the second optical signal. In addition, an example in which both the first optical signal and the second optical signal are positive chirp signals is used for description.

Because the first frequency variation upper limit is the same as the second frequency variation upper limit, and the first frequency sweep slope is the same as the second frequency sweep slope, in the frequency sweep control method shown in FIG. 7 and FIG. 8, states of different optical switch units may be controlled at equal time intervals, to implement alternate switching of optical signals.

As shown in FIG. 8, at a moment t0, the first laser unit 511 is turned on, and a positive chirp linear frequency sweep is performed with the first reference light emitting frequency F1 and the first frequency sweep slope. The first laser unit 511 is in a working state in a time interval from the moment t0 to a moment t3.

It should be understood that the first frequency variation of the first optical signal at the moment t0 is 0.

From a moment t1 to a moment t2, the first optical switch unit 521 is turned on, and the first optical signal is output through the optical combining unit 530. A state of the laser 500 is shown in (a) in FIG. 7. The first optical switch unit 521 is in the on state, and the second optical switch unit 522 is in the off state.

It should be understood that the first frequency variation of the first optical signal at the moment t1 is greater than or equal to a fourth threshold. The first frequency variation of the first optical signal at the moment t2 is greater than or equal to the first threshold.

It should be further understood that turning on the first optical switch unit 521 at the moment t1 provides higher optical signal linearity than turning on the first optical switch unit 521 at the moment t0.

At a moment t4, the second laser unit 512 is turned on, and a positive chirp linear frequency sweep is performed with the second reference light emitting frequency F2 and the second frequency sweep slope.

It should be understood that the moment t4 is earlier than the moment t2. In other words, when the first frequency variation of the first optical signal at the moment t4 is greater than or equal to the second threshold, the second laser unit 512 is turned on to perform a positive chirp linear frequency sweep, where the second threshold is less than the first threshold.

In this way, before the first frequency variation of the first optical signal reaches the first frequency variation upper limit, switching to output the second optical signal from the second laser unit is performed through an optical switch unit. This can avoid tens of microseconds of field of view interruption caused by a limitation of a basic modulation principle of the laser units before the first optical signal is greater than or equal to the first frequency variation upper limit, thereby improving ranging stability of the laser.

From a moment t5 to a moment t6, at the moment t5, the first optical switch unit 521 is turned off, the second optical switch unit 522 is turned on, and the second optical signal is output through the optical combining unit 530. The state of the laser 500 is shown in (b) in FIG. 7. The first optical switch unit 521 is in the off state, and the second optical switch unit 522 is in the on state.

It should be understood that, the moment t2 at which the first optical switch unit 521 is turned off to disable the output of the first optical signal is the same as the moment t5 at which the second optical switch unit 522 is turned on to output the second optical signal, or t5 is slightly later than t2.

It should be further understood that, when the moment t5 is slightly later than the moment t2, an interval between the moment t2 and the moment t5 is far less than a scanning time of a single beam position, and therefore field of view interruption caused in a time period by which the moment t5 is slightly later than the moment t2 may be ignored.

The first frequency variation upper limit is the same as the second frequency variation upper limit, and the first frequency sweep slope is the same as the second frequency sweep slope. Therefore, the second frequency variation of the second optical signal may also be greater than or equal to the fourth threshold at the moment t5, and the second frequency variation of the second optical signal may also be greater than or equal to the first threshold at the moment t6. In other words, a time interval between the moment t1 and the moment t2 may be the same as a time interval between the moment t5 and the moment t6.

At the moment t6, the second frequency variation of the second optical signal is greater than or equal to the third threshold. Because the first frequency variation upper limit is the same as the second frequency variation upper limit and the first frequency sweep slope is the same as the second frequency sweep slope, the third threshold may be the same as the first threshold.

At a moment t8, the first laser unit 511 is turned on, and a positive chirp linear frequency sweep is performed with the first reference light emitting frequency F1 and the first frequency sweep slope.

It should be understood that, from the moments t3 to the moment t8, a frequency sweep frequency of the first optical signal of the first laser unit 511 is restored to the first reference light emitting frequency.

From a moment t9 to a moment t10, at the moment t9, the second optical switch unit 522 is turned off, the first optical switch unit 521 is turned on, and the first optical signal is output through the optical combining unit 530. The state of the laser 500 is shown in (a) in FIG. 7. The first optical switch unit 521 is in the on state, and the second optical switch unit 522 is in the off state.

It should be understood that, the moment t6 at which the second optical switch unit 522 is turned off to disable output of the second optical signal is the same as the moment t9 at which the first optical switch unit 521 is turned on to output the first optical signal.

The first optical signal and the second optical signal are alternately output in time domain in the foregoing manner.

It should be understood that, when a quantity of laser units in the laser 500 is greater than 2, optical signals are output in the foregoing alternate output manner. An output sequence of the laser units in the laser is not limited in embodiments of this application.

In the foregoing technical solution, the first optical signal and the second optical signal are frequency-swept and output in time domain alternately. Because the reference light emitting frequencies of the first optical signal and the second optical signal are different, a frequency sweep range of the laser may be expanded. In the foregoing solution, the frequency variation upper limits of the first optical signal and the second optical signal are the same, and the frequency sweep slopes of the first optical signal and the second optical signal are the same. Therefore, turning on or turning off the optical switch units may be controlled at equal time intervals, to further reduce technical difficulty of alternately outputting optical signals.

However, the FMCW-based lidar still has a possibility of multi-lidar interference. In other words, when frequencies of detection optical signals sent by two lidars are close, and fields of view of the two lidars overlap, echo optical signals of the two lidars interfere with each other. For example, an echo optical signal of a lidar B is received by a lidar A, and coherent detection is performed on the echo optical signal and a local oscillation optical signal of the lidar A in the lidar A. As a consequence, a beat signal is generated. The beat signal presents different interference modes based on different frequency sweep slopes. For optical signals of two lidars with similar frequency sweep slopes, a false target is presented. For optical signals of two lasers with a large frequency sweep slope difference, an overall rise of the noise floor is presented.

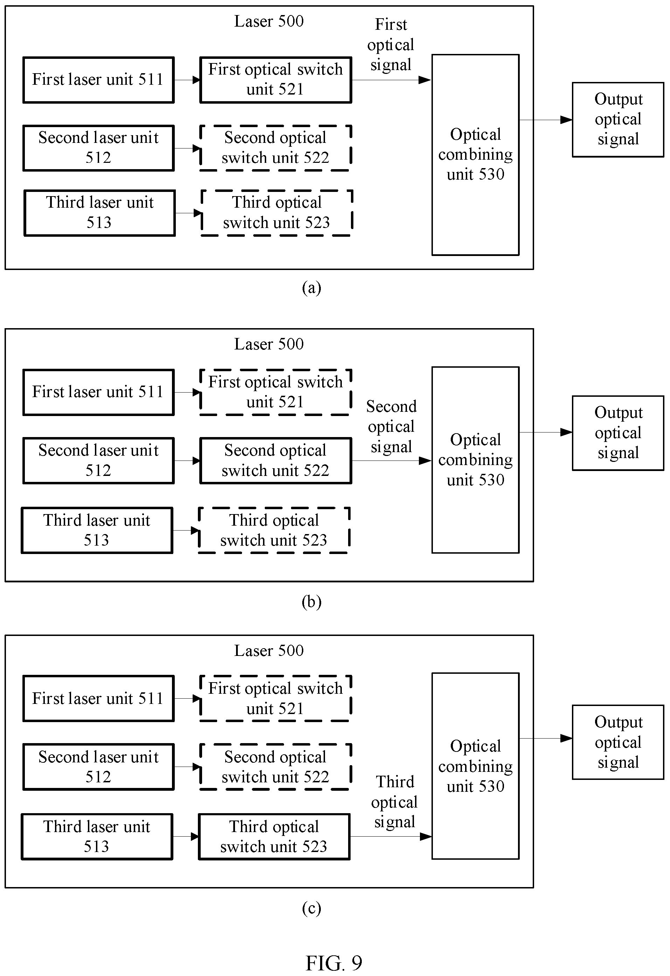

The following describes in detail a case in which multi-lidar interference occurs with reference to FIG. 9 to FIG. 12. It should be noted that FIG. 9 to FIG. 12 are described by using an example in which the laser 500 includes three laser units. In addition, frequency variation upper limits of all the laser units are the same, and frequency sweep slopes of all the laser units are the same.

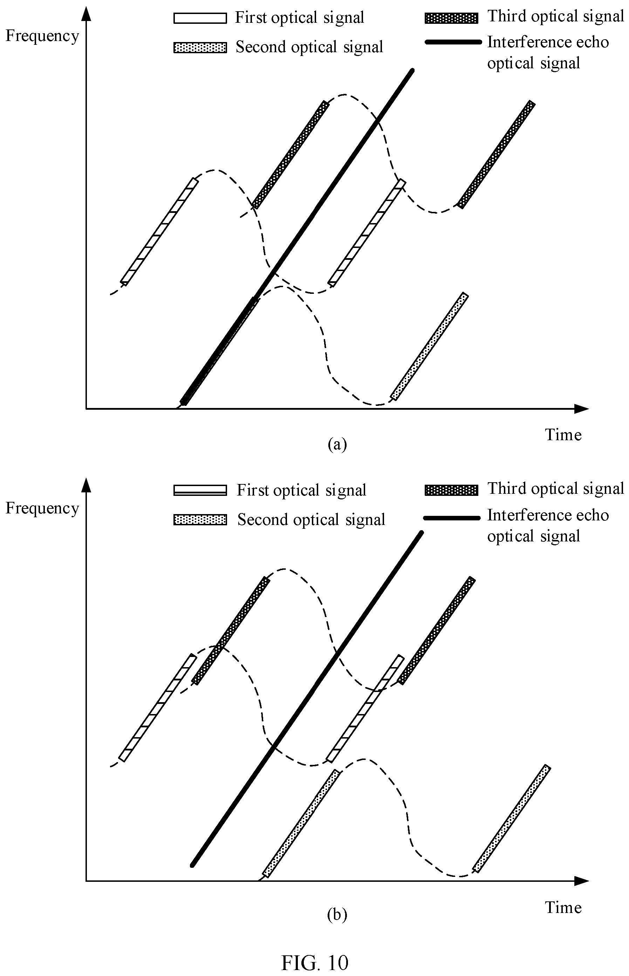

FIG. 9 is a diagram of another frequency sweep control process according to an embodiment of this application. FIG. 10 is a diagram of another frequency sweep result according to an embodiment of this application. With reference to FIG. 9 and FIG. 10, the following describes in detail a method for eliminating multi-lidar interference when an interference echo optical signal is a long chirp signal.

A sequence of optical signals output by the laser 500 alternately in (a) in FIG. 10 is the first optical signal, the second optical signal, and the third optical signal, and a sequence of changing working statuses of the optical switch units in the laser 500 is a sequence of (a) in FIG. 9, (b) in FIG. 9, and (c) in FIG. 9.

As shown in (a) in FIG. 9, the first optical switch unit 521 is in the on state, the second optical switch unit 522 is in the off state, and the third optical switch unit 523 is in an off state. The first optical signal is output from the optical combining unit 530 as an output optical signal.

As shown in (b) in FIG. 9, the first optical switch unit 521 is in the off state, the second optical switch unit 522 is in the on state, and the third optical switch unit 523 is in the off state. The second optical signal is output from the optical combining unit 530 as an output optical signal.

As shown in (c) in FIG. 9, the first optical switch unit 521 is in the off state, the second optical switch unit 522 is in the off state, and the third optical switch unit 523 is in the on state. The third optical signal is output from the optical combining unit 530 as an output optical signal.

The detection unit of the laser 500 determines that the interference echo signal interferes with an optical signal of the laser 500. For example, as shown in (a) in FIG. 10, a frequency difference between the interference echo signal and the second optical signal is less than the interference threshold, and a field of view of the first laser corresponding to the interference echo signal and a field of view of the second laser corresponding to the second optical signal overlap.

It should be understood that the second laser may be considered as the laser 500.

The interference echo signal shown in (a) in FIG. 10 is a long-chirp optical signal, and a sending sequence of the first optical signal, the second optical signal, and the third optical signal is adjusted, so that the second optical signal and the interference echo optical signal do not overlap in time domain.

As shown in (b) in FIG. 10, a sequence of optical signals output by the laser 500 alternately is the first optical signal, the third optical signal, and the second optical signal. A sequence of changing working statuses of the optical switch units in the laser 500 is (a) in FIG. 9, (c) in FIG. 9, and (b) in FIG. 9.

It should be understood that adjusting a light emitting sequence of the laser units to eliminate interference of the long-chirp interference echo signal shown in FIG. 9 and FIG. 10 is applicable to a laser having only two laser units. However, the long-chirp interference echo signal cannot cause interference to two optical signals at the same time. Therefore, the foregoing method in which the light emitting sequence of the laser units is adjusted to eliminate impact of the interference echo signal may be further applied to a laser having more than three laser units.

It should be further understood that the interference echo signal may interfere with any optical signal in the second laser. Herein, the second optical signal shown in (a) in FIG. 10 is used as an example for description. If interference exists between another optical signal and the interference optical echo signal, the foregoing manner may also be used to avoid the interference.

In the foregoing technical solution, the light emitting sequence of the laser units is adjusted, so that interference of the long chirp can be efficiently avoided, to maintain working stability of the laser.

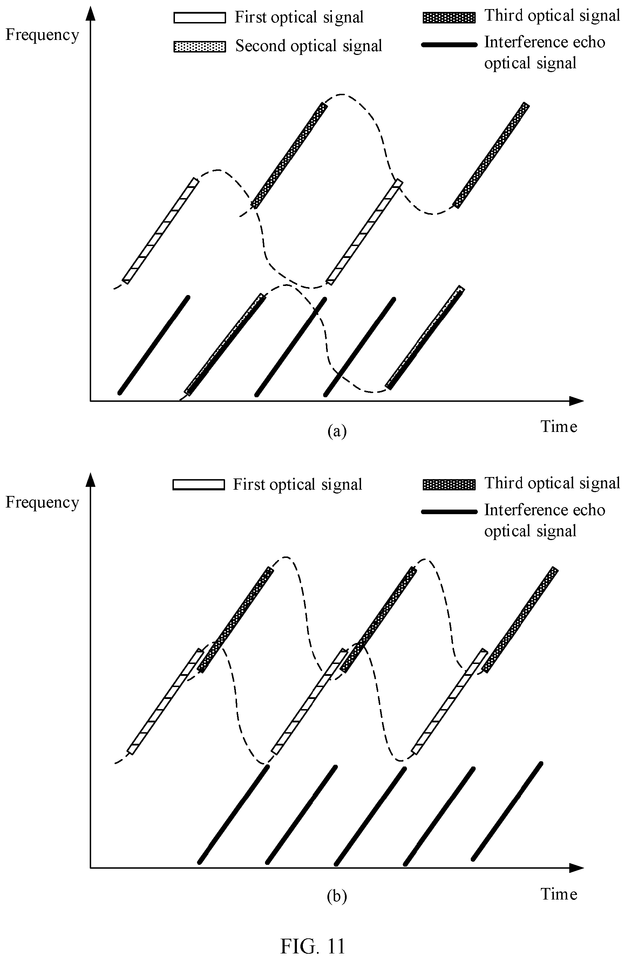

FIG. 11 is a diagram of still another frequency sweep result according to an embodiment of this application. With reference to FIG. 9 and FIG. 11, the following describes in detail a method for eliminating multi-lidar interference when an interference echo optical signal is a short chirp signal.

A sequence of optical signals output by the laser 500 alternately in (a) in FIG. 11 is the first optical signal, the second optical signal, and the third optical signal, and a sequence of changing working statuses of the optical switch units in the laser 500 is a sequence of (a) in FIG. 9, (b) in FIG. 9, and (c) in FIG. 9.

The detection unit of the laser 500 determines that the interference echo signal interferes with an optical signal of the laser 500. For example, as shown in (a) in FIG. 11, a frequency difference between the interference echo signal and the second optical signal is less than the interference threshold, and a field of view of the first laser corresponding to the interference echo signal and a field of view of the second laser corresponding to the second optical signal overlap.

It should be understood that the second laser may be considered as the laser 500. The interference echo signal may interfere with any optical signal in the second laser. Herein, the second optical signal shown in (a) in FIG. 10 is used as an example for description.

The interference echo signal shown in (a) in FIG. 11 is a short-chirp optical signal, the second optical switch unit 522 is turned off to disable output of the second optical signal, and the statuses of the first optical switch unit 521 and the third optical switch unit 523 are adjusted, so that the first optical signal and the second optical signal are contiguously output in time domain.

Adjusted output optical signals are shown in (b) in FIG. 11, and a sequence of optical signals output by the laser 500 alternately is the first optical signal and the third optical signal. A sequence of changing working statuses of the optical switch units in the laser 500 is (a) in FIG. 9 and (c) in FIG. 9. In other words, the second optical switch unit 522 is turned off, and the first optical switch unit 521 and the third optical switch unit 523 are adjusted, so that the first optical signal and the third optical signal are output alternately.

It should be understood that the case in which multi-lidar interference is eliminated when the interference echo optical signal is a short chirp is applicable to a laser including three or more laser units.

It should be further understood that the interference echo signal may interfere with any optical signal in the second laser. Herein, the second optical signal shown in (a) in FIG. 11 is used as an example for description. If interference exists between another optical signal and the interference optical echo signal, the foregoing manner may also be used to avoid the interference.

In the foregoing technical solution, the light emitting sequence of the laser units is adjusted, and output of an interfered optical signal is shielded, so that interference of the short chirp can be efficiently avoided, to maintain working stability of the laser.

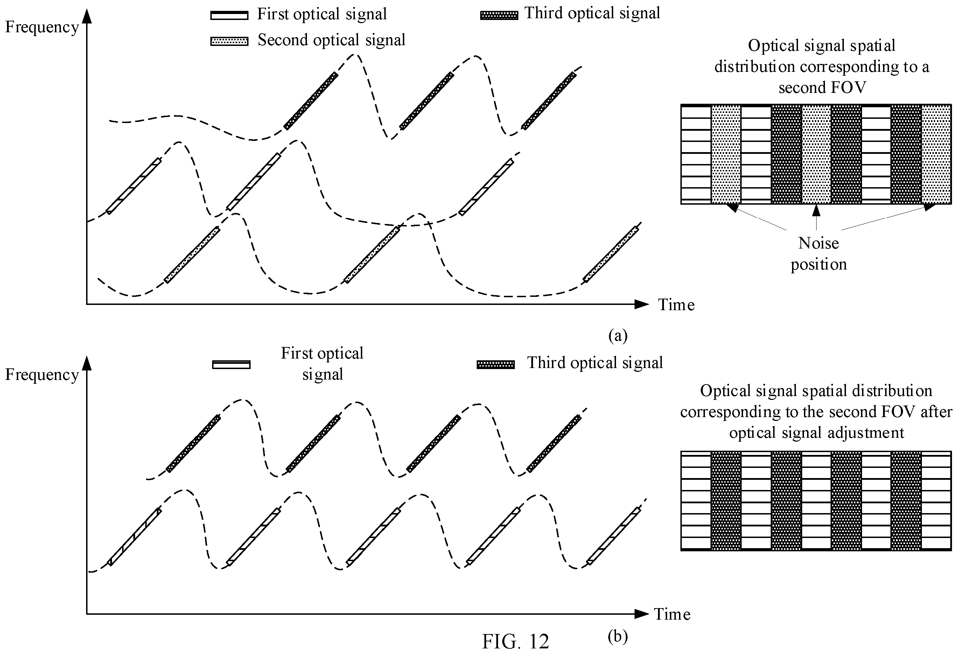

FIG. 12 is a diagram of yet another frequency sweep result according to an embodiment of this application. With reference to FIG. 9 and FIG. 12, the following describes in detail a method for identifying an interference echo signal and a method for eliminating the interference echo signal.

The laser 500 alternately outputs optical signals in a random light emitting sequence of the laser units. As shown in (a) in FIG. 12, a random alternating light emitting sequence of the optical signals is the first optical signal, the second optical signal, the first optical signal, the third optical signal, the second optical signal, the third optical signal, the first optical signal, the third optical signal, the second optical signal, and the like.

Correspondingly, a sequence of changing working statuses of the optical switch units in the laser 500 is (a), (b), (a), (c), (b), (c), (a), (c), and (b) in FIG. 9.

When it is detected that noise exists in the second field of view, and spatial distribution of the noise in the second field of view and spatial distribution of the second optical signal in the second field of view overlap, the detection unit of the laser 500 determines that the second optical signal and an interference echo optical signal corresponding to the noise interfere with each other.

As shown in optical signal spatial distribution corresponding to the second field of view in (a) in FIG. 12, noise appears in the spatial distribution of the second optical signal in the second field of view, and it is determined that the second optical signal and an interference echo optical signal corresponding to the noise interfere with each other.

The control unit of the laser 500 obtains time domain positions of the first optical signal, the second optical signal, and the third optical signal, and disables the output of the first optical signal at the corresponding time domain position of the second optical signal.

Specifically, the laser 500 filters out an echo optical signal of the second optical signal from a current frame.

Alternatively, specifically, as shown in (b) in FIG. 12, the laser 500 alternately outputs the first optical signal and the third optical signal in a next frame. A sequence of changing working statuses of the optical switch units in the laser 500 is (a) in FIG. 9 and (c) in FIG. 9. In other words, the second optical switch unit 522 is turned off, and the first optical switch unit 521 and the third optical switch unit 523 are adjusted, so that the first optical signal and the third optical signal are output alternately.

In the foregoing technical solution, the interference echo optical signal is identified based on a random light emitting sequence of the laser units, and output of an interfered optical signal is shielded, so that interference of the short chirp can be efficiently avoided, to maintain working stability of the laser.

A person of ordinary skill in the art may be aware that, in combination with the examples described in embodiments disclosed in this specification, units and algorithm steps can be implemented by electronic hardware or a combination of computer software and electronic hardware. Whether the functions are performed by hardware or software depends on a particular application and a design constraint condition of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus, and method may be implemented in another manner. For example, the described apparatus embodiments are merely examples. For example, the division of units is merely logical function division and may be other division in actual implementation. For example, a plurality of units or components may be combined or integrated into another system, or some features may be ignored or may not be performed. In addition, the displayed or discussed mutual couplings or direct couplings or communication connections may be implemented by using some interfaces. The indirect couplings or communication connections between apparatuses or units may be implemented in electronic, mechanical, or other forms.

The units described as separate components may or may not be physically separate, and components displayed as units may or may not be physical units, may be located in one position, or may be distributed on a plurality of network units. Some or all of the units may be selected based on actual requirements to achieve objectives of solutions of embodiments.

In addition, functional units in embodiments of this application may be integrated into one processing unit, each of the units may exist alone physically, or two or more units may be integrated into one unit.

When the functions are implemented in the form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, a network device, or the like) to perform all or some of the steps in the methods described in embodiments of this application. The foregoing storage medium includes: any medium that can store program code, such as a USB flash drive, a removable hard disk, a read-only memory (Read-Only Memory, ROM), a random access memory (Random Access Memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A frequency sweep control method, wherein the method comprises:
outputting a first optical signal of a first laser unit, wherein a first frequency sweep range of the first optical signal is determined based on a first reference light emitting frequency and a first frequency variation upper limit; and
switching to output a second optical signal of a second laser unit when a first frequency variation of the first optical signal is greater than or equal to a first threshold, wherein a second frequency sweep range of the second optical signal is determined based on a second reference light emitting frequency and a second frequency variation upper limit, and the first threshold is less than the first frequency variation upper limit; and
the first frequency sweep range and the second frequency sweep range partially overlap, or the first frequency sweep range and the second frequency sweep range do not overlap, and the first reference light emitting frequency and the second reference light emitting frequency are different.

2. The method according to claim 1, wherein
switching to output the second optical signal of the second laser unit when the first frequency variation of the first optical signal is greater than or equal to the first threshold comprises:
when the first frequency variation is greater than or equal to a second threshold, turning on the second laser unit, and when the first frequency variation is greater than or equal to the first threshold, switching to output the second optical signal, wherein the second threshold is less than the first threshold.

3. The method according to claim 1 or 2, wherein the method further comprises:
when a second frequency variation of the second optical signal is greater than or equal to a third threshold, switching to output another optical signal other than the second optical signal, wherein the third threshold is less than the second frequency variation upper limit.

4. The method according to claim 3, wherein the method further comprises:
determining that the first optical signal and an interference echo optical signal interfere with each other, wherein a frequency difference between a frequency of the first optical signal and a frequency of the interference echo optical signal is less than an interference threshold, and a first field of view and a second field of view overlap; and
adjusting a sending strategy for the first optical signal, the second optical signal, and the another optical signal, wherein
a first laser corresponding to the interference echo optical signal is different from a second laser corresponding to the first optical signal, the first field of view is a field of view of the first laser, and the second field of view is a field of view of the second laser.

5. The method according to claim 4, wherein adjusting the sending strategy for the first optical signal, the second optical signal, and the another optical signal comprises:
when the interference echo optical signal is a long-chirp optical signal, adjusting a sending sequence of the first optical signal, the second optical signal, and the another optical signal, so that the first optical signal and the interference echo optical signal do not overlap in time domain.

6. The method according to claim 4, wherein the another optical signal is a third optical signal, and the third optical signal is determined based on a third reference light emitting frequency and a third frequency variation upper limit; and
adjusting the sending strategy for the first optical signal, the second optical signal, and the another optical signal comprises:
when the interference echo optical signal is a short-chirp optical signal, disabling the output of the first optical signal, and adjusting a sending sequence of the second optical signal and the third optical signal, wherein the second optical signal and the third optical signal are contiguous in time domain.

7. The method according to claim 3, wherein the another optical signal is a third optical signal, and the third optical signal is determined based on a third reference light emitting frequency and a third frequency variation upper limit; and
the method further comprises:
alternately outputting the first optical signal, the second optical signal, and the third optical signal in a random sequence;
when it is detected that noise exists in a first field of view, and spatial distribution of the noise in the second field of view and spatial distribution of the first optical signal in the second field of view overlap, determining that the first optical signal and an interference echo optical signal corresponding to the noise interfere with each other; and
adjusting a sending strategy for the first optical signal, the second optical signal, and the third optical signal, wherein
a first laser corresponding to the interference echo optical signal is different from a second laser corresponding to the first optical signal, and the second field of view is a field of view of the second laser.

8. The method according to claim 7, wherein adjusting the sending strategy for the first optical signal, the second optical signal, and the third optical signal comprises:
obtaining time domain positions of the first optical signal, the second optical signal, and the third optical signal that are randomly sent; and
disabling the output of the first optical signal at the time domain position for sending the first optical signal.

9. A frequency sweep control apparatus, wherein the apparatus comprises a first laser unit, a second laser unit, a first optical switch unit, a second optical switch unit, and an optical combining unit;
the first laser unit is configured to send a first optical signal to the optical combining unit through the first optical switch unit, wherein a first frequency sweep range of the first optical signal is determined based on a first reference light emitting frequency and a first frequency variation upper limit, and the first optical switch unit is in an on state;
the optical combining unit is configured to output the first optical signal;
the second laser unit is configured to send a second optical signal to the optical combining unit through the second optical switch unit when a first frequency variation of the first optical signal is greater than or equal to a first threshold, wherein a second frequency sweep range of the second optical signal is determined based on a second reference light emitting frequency and a second frequency variation upper limit, and the first threshold is less than the first frequency variation upper limit; and
the optical combining unit switches to output the second optical signal, wherein the first optical switch unit is in an off state, and the second optical switch unit is in an on state; and
the first frequency sweep range and the second frequency sweep range partially overlap, or the first frequency sweep range and the second frequency sweep range do not overlap, and the first reference light emitting frequency and the second reference light emitting frequency are different.

10. The apparatus according to claim 9, wherein when the first frequency variation is greater than or equal to a second threshold, the second laser unit is turned on, and when the first frequency variation is greater than or equal to the first threshold, the second laser unit is configured to send the second optical signal to the optical combining unit through the second optical switch unit, wherein the second threshold is less than the first threshold.

11. The apparatus according to claim 9 or 10, wherein when a second frequency variation of the second optical signal is greater than or equal to a third threshold, the optical combining unit switches to output another optical signal other than the second optical signal, wherein the second optical switch unit is in an off state, and the third threshold is less than the second frequency variation upper limit.

12. The apparatus according to claim 11, wherein the apparatus further comprises another optical switch unit, a detection unit, and a control unit;
the detection unit is configured to determine that the first optical signal and an interference echo optical signal interfere with each other, wherein a frequency difference between a frequency of the first optical signal and a frequency of the interference echo optical signal is less than an interference threshold, and a first field of view and a second field of view overlap; and
the control unit is configured to control the first optical switch unit, the second optical switch unit, and the another optical switch unit, to adjust a sending strategy for the first optical signal, the second optical signal, and the another optical signal, wherein
a first laser corresponding to the interference echo optical signal is different from a second laser corresponding to the first optical signal, the first field of view is a field of view of the first laser, and the second field of view is a field of view of the second laser.

13. The apparatus according to claim 12, wherein the control unit is specifically configured to:
when the interference echo optical signal is a long-chirp optical signal, control the first optical switch unit, the second optical switch unit, and the another optical switch unit, to adjust a sending sequence of the first optical signal, the second optical signal, and the another optical signal, so that the first optical signal and the interference echo optical signal do not overlap in time domain.

14. The apparatus according to claim 12, wherein the another optical switch unit is a third optical switch unit, the another optical signal is a third optical signal, and the third optical signal is determined based on a third reference light emitting frequency and a third frequency variation upper limit; and
the control unit is specifically configured to:
when the interference echo optical signal is a short-chirp optical signal, control the first optical switch unit to disable the output of the first optical signal, and control the first optical switch unit and the third optical switch unit, to adjust a sending sequence of the second optical signal and the third optical signal, wherein the second optical signal and the third optical signal are contiguous in time domain.

15. The apparatus according to claim 11, wherein the another optical signal is a third optical signal, and the third optical signal is determined based on a third reference light emitting frequency and a third frequency variation upper limit;
the apparatus further comprises a third optical switch unit, a detection unit, and a control unit; the control unit is configured to control the first optical switch unit, the second optical switch unit, and the third optical switch unit, so that the first optical signal, the second optical signal, and the third optical signal are alternately output in a random sequence;
the detection unit is configured to: when it is detected that noise exists in a second field of view, and spatial distribution of the noise in the second field of view and spatial distribution of the first optical signal in the second field of view overlap, determine that the first optical signal and the interference echo optical signal corresponding to the noise interfere with each other; and
the control unit is configured to control the first optical switch unit, the second optical switch unit, and the third optical switch unit, to adjust a sending strategy for the first optical signal, the second optical signal, and the third optical signal, wherein
a first laser corresponding to the interference echo optical signal is different from a second laser corresponding to the first optical signal, and the second field of view is a field of view of the second laser.

16. The apparatus according to claim 15, wherein the control unit is specifically configured to:
obtain time domain positions of the first optical signal, the second optical signal, and the third optical signal that are randomly sent; and
control the first optical switch unit to disable the output of the first optical signal at the corresponding time domain position for sending the first optical signal.

17. A lidar, comprising the frequency sweep control apparatus according to any one of claims 9 to 16.

18. A mobile carrier, comprising the lidar according to claim 17.

19. The mobile carrier according to claim 18, wherein the mobile carrier is a vehicle.
